# EUROPÄISCHE PATENTANMELDUNG

(11) **EP 2 463 693 A2**
(43) Veröffentlichungstag der Anmeldung: **13.06.2012**
(21) Anmeldenummer: 12152649.5
(22) Anmeldetag: 01.04.2010
(51) Int. Cl.: G02B 5/22, G02B 26/08, G02B 5/08, G03F 7/20

(54) **Mikrospiegelanordnung mit Beschichtung sowie Verfahren zu deren Herstellung**

(30) Priorität: 15.07.2009 DE 102009033511; 20.08.2009 DE 102009038000
(62) Teilanmeldung aus: 10714601.1
(71) Anmelder: Carl Zeiss SMT GmbH, 73447 Oberkochen (DE)
(72) Erfinder: Weißenrieder, Karl-Stefan, 89275 Elchingen (DE); Lörcher, Roland, 73434 Aalen-Hofherrnweiler (DE); Pazidis, Alexandra, 73457 Essingen-Lautenburg (DE)
(74) Vertreter: Carl Zeiss AG - Patentabteilung

(57) **Zusammenfassung**

Die Erfindung betrifft eine Mikrospiegelanordnung (1), umfassend: mindestens einen Mikrospiegel (3) mit einer reflektierenden Oberfläche (11), die an einem Spiegelsubstrat (2) gebildet ist, sowie eine Anti-Reflexbeschichtung (7), die an dem Spiegelsubstrat (2) außerhalb der reflektierenden Oberfläche (11) gebildet ist. Eine reflektierende Beschichtung (8) ist innerhalb der reflektierenden Oberfläche (11) gebildet und weist wenigstens zwei Schichtteilsysteme auf, wobei das erste Schichtteilsystem Schichten (8e, 8f) aus einer periodischen Abfolge alternierender hoch und niedrig brechender Schichten aus einem nicht-metallischen Material aufweist und bezüglich einer Nutzwellenlänge der Mikrospiegelanordnung im Hinblick auf die Reflektivität optimiert ist und wobei das zweite Schichtteilsystem bezüglich einer von der Nutzwellenlänge abweichenden Messwellenlänge der Mikrospiegelanordnung im Hinblick auf die Reflektivität optimiert ist. Die Erfindung betrifft auch ein Verfahren zur Herstellung einer Beschichtung, wobei die Beschichtung eine reflektierende Beschichtung (8) und eine Anti-Reflexbeschichtung (7) umfasst. Die Anti-Reflexbeschichtung (7) kann hierbei insbesondere zur Kompensation der Schichtspannung einer reflektierenden Beschichtung (8) dienen.

## Beschreibung

### Hintergrund der Erfindung

Die Erfindung betrifft eine Mikrospiegelanordnung, umfassend: mindestens einen Mikrospiegel mit einer reflektierenden Oberfläche, die an einem Spiegelsubstrat gebildet ist, sowie eine Anti-Reflexbeschichtung, die an dem Spiegelsubstrat außerhalb der reflektierenden Oberfläche gebildet ist. Die Erfindung betrifft auch ein Verfahren zur Herstellung einer Beschichtung für eine Mikrospiegelanordnung.

Mikrospiegelanordnungen weisen eine Mehrzahl von Mikrospiegeln auf, die in einer flächigen, in der Regel matrixförmigen Anordnung nebeneinander angeordnet sind und unabhängig voneinander bewegt werden können. Typischer Weise ist die optische Oberfläche eines einzelnen Mikrospiegels relativ zu einer allen Mikrospiegeln gemeinsamen Ebene beweglich, insbesondere verkippbar gelagert. Zur Erzeugung der Bewegung bzw. Verkippung können unter dem Mikrospiegel Elektroden angebracht sein, die das Spiegelsubstrat elektrostatisch anziehen. Durch die Verkippung der einzelnen Mikrospiegel können diese die einfallende Strahlung gezielt in unterschiedliche Raumrichtungen reflektieren und so z.B. zur Pupillenformung in Beleuchtungssystemen für die Mikrolithographie eingesetzt werden.

Es ist bekannt, dass die Mikrospiegelanordnungen mit reflektierenden Beschichtungen versehen werden können, um die Reflektivität einer solchen Mikrospiegelanordnung bei einer Nutzwellenlänge gegenüber der natürlichen Reflektivität des Substratmaterials der Mikrospiegelanordnung zu erhöhen. In der Regel bestehen solche Beschichtungen für Mikrospiegelanordnungen aus dielektrisch verstärkten Metallschichten, siehe US 7307775, US 6816302, US 6778315, US 6891655, WO 2006000445, US 5572543 und US 6746886.

Nachteilig an diesen Schichten ist jedoch, dass diese Beschichtungen unter intensiver Bestrahlung degradieren und mit der Zeit sogenannte "Hillock's", dies sind kleine Erhöhungen auf der Oberfläche mit in der Regel kreisförmigem Querschnitt, sowie eine erhöhte Rauheit aufweisen, welche zu erhöhtem Streulicht dieser Schichten führt. Des Weiteren ist an diesen Schichten nachteilig, dass sie nicht gleichzeitig für Licht einer anderen Wellenlänge geeignet sind, welches unter großen Einfallswinkeln zur Normalen der Spiegelfläche einfällt. Solches Licht mit einer Messwellenlänge, welche von der Nutzwellenlänge abweicht, wird zu Kalibrierzwecken für Mikrospiegelanordnungen in einem Beleuchtungssystem für die Mikrolithographie benötigt.

Da bautechnisch bedingt die reflektierenden Oberflächen der Mikrospiegel in der Regel nicht unmittelbar benachbart zueinander angeordnet werden können, trifft die auf die Mikrospiegelanordnung einfallende Strahlung nicht nur die reflektierenden Oberflächen der einzelnen Mikrospiegel, sondern auch Bereiche, in denen keine Reflexion der Strahlung gewünscht ist. Der außerhalb der reflektierenden Oberflächen der einfallenden Strahlung ausgesetzte Bereich der Mikrospiegelanordnung sollte möglichst wenig Strahlung reflektieren bzw. zurückstreuen, da diese beispielsweise bei Verwendung der Mikrospiegelanordnung zur Pupillenformung unmittelbar in den Bereich der Pupille als Störlicht reflektiert wird.

Aus der US 6,891,655 B2 sind eine Mikrospiegelanordnung und ein Verfahren zu deren Herstellung bekannt geworden, bei denen die Beständigkeit eines Mikrospiegels für Strahlung im UV-Wellenlängenbereich durch Aufbringen einer strahlungsbeständigen Schicht erhöht werden soll. Es wird weiterhin vorgeschlagen, auf die Rückseite des Mikrospiegels und/oder an einem unbeweglichen Substrat, an dem der Mikrospiegel gelagert ist, eine Anti-Reflexbeschichtung aufzubringen. Als Materialien für die Schichten der Anti-Reflexbeschichtung werden unter anderem Magnesium-Fluorid und Calcium-Fluorid vorgeschlagen.

Zur Reduzierung der Reflektivität der Mikrospiegelanordnung außerhalb der optischen Oberflächen kann auch eine die einfallende Strahlung auffangende Blende vorgesehen sein. Nachteilig an dieser Lösung ist aber deren geringe mechanische Stabilität, sowie die ggf. nicht ausreichende Genauigkeit bei deren Befestigung bzw. Justage.

### Aufgabe der Erfindung

Aufgabe der Erfindung ist es, eine Mikrospiegelanordnung und ein Verfahren zur Herstellung einer Beschichtung anzugeben, wobei die Beschichtung unter intensiver Bestrahlung von Licht der Nutzwellenlänge nicht degradiert und gleichzeitig für Licht einer anderen Wellenlänge als der Nutzwellenlänge geeignet ist. Ferner soll die Beschichtung außerhalb der reflektierenden Fläche eines Mikrospiegels möglichst wenig Licht reflektieren, um Störlicht zu vermeiden.

### Gegenstand der Erfindung

Diese Aufgabe wird erfindungsgemäß dadurch gelöst, dass die Mikrospiegelanordnung mindestens einen Mikrospiegel mit einer reflektierenden Oberfläche umfasst, die an einem Spiegelsubstrat gebildet ist, wobei an dem Spiegelsubstrat innerhalb der reflektierenden Oberfläche eine reflektierende Beschichtung gebildet ist, wobei eine Anti-Reflexbeschichtung, die an dem Spiegelsubstrat außerhalb der reflektierenden Oberfläche gebildet ist, wenigstens eine absorbierende Schicht aus einem bevorzugt nicht-metallischen Material aufweist, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist. Durch die Verwendung einer reflektierenden Beschichtung innerhalb der reflektierenden Oberfläche und einer Anti-Reflexbeschichtung außerhalb der reflektierenden Oberfläche des Mikrospiegels ist es möglich, einerseits die gewünschten Reflektivitätseigenschaften bereitzustellen und andererseits das unerwünschte Störlicht zu unterdrücken.

Bei einer Ausführungsform weist die Anti-Reflexbeschichtung der Mikrospiegelanordnung unter senkrechtem Einfall in einem Wellenlängenbereich zwischen 185 nm und 210 nm, insbesondere bis 230 nm eine Reflektivität von 10 % oder weniger, bevorzugt von 5 % oder weniger auf. Hierdurch wird insbesondere der Einsatz einer solchen Mikrospiegelanordnung für die Mikrolithographie bei einer Wellenlänge von 193 nm ermöglicht, da das Störlicht durch die Anti-Reflexbeschichtung ausreichend unterdrückt wird.

Darüber hinaus wird die Aufgabe erfindungsgemäß dadurch gelöst, dass die Mikrospiegelanordnung mindestens einen Mikrospiegel mit einer reflektierenden Oberfläche umfasst, die an einem Spiegelsubstrat gebildet ist, wobei an dem Spiegelsubstrat innerhalb der reflektierenden Oberfläche eine reflektierende Beschichtung gebildet ist, welche wenigstens zwei Schichtteilsysteme aufweist. Dabei besteht das erste Schichtteilsystem aus einer periodischen Abfolge alternierender hoch und niedrig brechender Schichten aus einem nicht-metallischen Material und ist bezüglich einer Nutzwellenlänge der Mikrospiegelanordnung im Hinblick auf die Reflektivität optimiert. Darüber hinaus ist das zweite Schichtteilsystem der reflektierenden Beschichtung bezüglich einer von der Nutzwellenlänge abweichenden Messwellenlänge der Mikrospiegelanordnung im Hinblick auf die Reflektivität optimiert. In einer Ausführungsform besteht das Spiegelsubstrat aus Silizium und die reflektierende Beschichtung ist als eine strukturierte Beschichtung derart ausgeführt, dass die reflektierende Beschichtung auf die Fläche der reflektierenden Oberfläche des Mikrospiegels begrenzt ist.

Unter einer hoch brechenden Schicht wird im Rahmen dieser Anmeldung eine Schicht aus einem Material verstanden, das bei der Nutz- oder Messwellenlänge verglichen mit dem Material der anderen Schicht der zugehörigen Periode das entsprechende Licht stärker bricht. Umgekehrt gilt für eine niedrig brechende Schicht, dass das Material diese Schicht bei einem Vergleich mit dem Material der anderen Schicht der zugehörigen Periode das entsprechende Licht weniger stark bricht.

Als Nutzwellenlänge einer Mikrospiegelanordnung wird im Rahmen dieser Anmeldung die Wellenlänge des Nutzlichtes verstanden, welchem die Mikrospiegelanordnung bei der beabsichtigten Nutzung ausgesetzt ist. Im Falle der Mikrolithographie ist dies die Nutzwellenlänge 193 nm oder 248 nm.

Die Messwellenlänge ist eine von der Nutzwellenlänge um mindestens 50 nm abweichende Wellenlänge des Messlichtes mit Hilfe dessen die Mikrospiegelanordnung während des Betriebs kalibriert wird. Im Falle der Mikrolithographie liegt die Messwellenlänge vorteilhaft im sichtbaren oder infraroten Spektralbereich.

Die Reflektivität einer Oberfläche oder einer Beschichtung wird im Rahmen dieser Anmeldung als Verhältnis der Intensität der reflektierten Strahlung zu der Intensität der einfallenden Strahlung in der Einheit [%] angegeben.

Durch die Nutzung von mindestens zwei Schichtteilsystemen für die reflektierende Beschichtung einer Mikrospiegelanordnung kann diese sowohl im Hinblick auf die Nutzwellenlänge als auch im Hinblick auf eine zusätzliche Messwellenlänge durch die Auslegung des entsprechenden Schichtteilsystems auf die jeweilige ihm zugrunde liegende Aufgabe gleichzeitig optimiert werden. Ferner kann durch die Vermeidung von Metallschichten im ersten Schichtteilsystem vermieden werden, wie von den Erfindern erkannt wurde, dass das erste Schichtteilsystem mit der Zeit bei intensiver Bestrahlung degradiert. Dabei ist es vorteilhaft, wenn das erste Schichtteilsystem in Richtung der Flächennormalen vom Substrat aus gesehen nach dem zweiten Schichtteilsystem folgt, da dann das Nutzlicht im wesentlichen durch das erste Schichtteilsystem reflektiert wird und somit durch das darunter befindliche zweite Schichtteilsystem im wesentlichen nicht beeinflusst wird.

Bei einer Ausführungsform weist die reflektierende Beschichtung mindestens eine Trennschicht zwischen den zwei Schichtteilsystemen auf, wobei das Material der Trennschicht ein Material ist, das bevorzugt ausgewählt ist aus der Gruppe umfassend: TiO₂, Ta₂O₅, HfO₂, ZrO₂, Si, Ge, ZnS, CuInSe₂, CuInS₂, La₂O₃. Diese Trennschicht ist im Wesentlichen undurchlässig für das Licht der Nutzwellenlänge und zumindest teildurchlässig für das Licht der Messwellenlänge. Somit können die zwei Schichtteilsystem hinsichtlich der Reflektivitätseigenschaften auch für den Fall entkoppelt werden, dass die Schichtteilsysteme aus einer geringen Anzahl von Schichten bestehen, welche das Licht nicht vollständig reflektieren. Vorteilhaft besteht die Trennschicht aus einem Material, dessen Bandkante zwischen der Nutzwellenlänge und der Messwellenlänge liegt.

In einer weiteren Ausführungsform bestehen die Schichten des ersten Schichtteilsystems aus Materialien, welche ausgewählt sind aus der Gruppe umfassend: LaF₃, MgF₂, SiO₂, Al₂O₃, ErF₃, GdF₃, HfO₂, AlF₃. Hierdurch lassen sich besonders hohe Reflektivitätswerte bei einer gleichzeitig geringen Anzahl von Schichten bei der Nutzwellenlänge im ersten Schichtteilsystem realisieren.

Bei einer Ausführungsform bestehen die Schichten des zweiten Schichtteilsystems aus Materialien, welche ausgewählt sind aus der Gruppe umfassend: La₂O₃, ZrO₂, TiO₂, Ta₂O₅, MgF₂, SiO₂, Al₂O₃, Si, Ge, HfO₂, AlF₃. Hierdurch lassen sich insbesondere für Licht im sichtbaren oder infraroten Wellenlängenbereich hohe Reflektivitätswerte der reflektierenden Beschichtung realisieren.

In einer weiteren Ausführungsform weist der mindestens eine Mikrospiegel der Mikrospiegelanordnung eine Anti-Reflexbeschichtung auf, welche wenigstens eine absorbierende Schicht aus einem nicht-metallischen Material aufweist, das bei einer Wellenlänge im UV-Bereich, insbesondere bei 193 nm, einen Absorptionskoeffizienten (Imaginärteil des Brechungsindex) von 0,1 oder mehr, bevorzugt von 0,2 oder mehr, insbesondere von 0,4 oder mehr aufweist.

Die Anti-Reflexbeschichtung ist in einer Ausführungsform benachbart zu den reflektierenden Oberflächen auf dem Spiegelsubstrat angeordnet und sollte möglichst die gesamte Fläche außerhalb der reflektierenden Oberflächen bedecken, was in der Regel nur erreicht werden kann, wenn die Anti-Reflexbeschichtung strukturiert wird, wobei die Toleranzen bei der Strukturierung der Anti-Reflexbeschichtung so gering wie möglich ausfallen sollten. Als Verfahren zur Strukturierung der Anti-Reflexbeschichtung mit niedrigen Toleranzen ist die Fotolithographie besonders gut geeignet. In einer Ausführungsform besteht das Spiegelsubstrat hierbei aus Silizium.

Bei einer Ausführungsform ist das Material der absorbierenden Schicht eine Verbindung, die ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}). Hierbei handelt es sich um Materialien, die in standardisierten Prozessen als dünne Schichten aufgebracht werden können, und zwar insbesondere durch plasmaunterstützte chemische Gasphasenabscheidung (PECVD), durch thermisches Verdampfen oder durch Sputtern.

Weiterhin kann bei einer Ausführungsform, bei der auf der Anti-Reflexbeschichtung die reflektierenden Beschichtung aufgebracht wird, die Schichtspannung der Anti-Reflexbeschichtung unter Verwendung der genannten Materialien zur Kompensation der Schichtspannung der reflektierenden Beschichtung eingesetzt werden. Die Gesamtspannung der Beschichtung, welche die reflektierende Beschichtung und die Anti-Reflexbeschichtung umfasst, sollte dabei einen Wert von 100 N/m, wenn möglich sogar 30 N/m nicht überschreiten, um eine Deformation des Mikrospiegels zu vermeiden.

Auch sind die genannten Schichtmaterialien weitgehend selektiv zum Silizium-Substrat ätzbar, d.h. es tritt beim Abätzen, insbesondere beim nasschemischen Abätzen, in der Regel eine vernachlässigbare Dickenänderung des Siliziums auf. Der Absorptionskoeffizient (Imaginärteil des Brechungsindex) der oben beschriebenen Materialien kann in Abhängigkeit von der Art der Auftragung variieren und z.B. bei SiN für eine Wellenlänge von 193 nm in einem Bereich zwischen 0,17 und 0,3 oder auch höher, bis ca. 0,7 liegen, vgl. für Details hierzu die US 6 319 568 B1, welche bezüglich dieses Aspekts durch Bezugnahme zum Inhalt dieser Anmeldung gemacht wird.

In einer weiteren Ausführungsform ist auf die absorbierende Schicht mindestens eine weitere Schicht mit einem niedrigeren Brechungsindex als dem Brechungsindex der absorbierenden Schicht aufgebracht. Die weitere Schicht dient zur Vermeidung bzw. Verringerung von Reflexionen bei der Einkopplung der einfallenden Strahlung in die absorbierende Schicht und besteht aus einem gegenüber der einfallenden Strahlung transparenten Material, das einen vergleichsweise niedrigen Absorptionskoeffizienten aufweist, der z.B. bei weniger als 0,001 liegen kann. Es versteht sich, dass auch transparente Schichten mit höheren Absorptionskoeffizienten, z.B. 0,015 oder darüber, verwendet werden können. Auch kann die Anti-Reflexbeschichtung eine Mehrzahl von übereinander angeordneten Schichtpaaren aufweisen, die jeweils aus einer absorbierenden und einer transparenten Schicht bestehen.

In einer Ausführungsform besteht die weitere Schicht aus MgF₂, LaF₃, Chiolith, Kryolith, Al₂O₃, ErF₃ oder einer Silizium-Sauerstoff-Verbindung, insbesondere aus Siliziumdioxid (SiO₂). Siliziumdioxid weist bei einer Wellenlänge von 193 nm einen Absorptionskoeffizienten von ca. 0,0002 oder mehr auf, der ebenfalls in Abhängigkeit von den Beschichtungsbedingungen variieren kann. Ebenso kann bei einer Nutzwellenlänge von 248 nm HfO₂ als weitere transparente Schicht genutzt werden. In diesem Fall kann HfO₂ dann nicht als absorbierende Schicht fungieren.

In einer weiteren Ausführungsform bestehen alle Schichten der Anti-Reflexbeschichtung aus nicht-metallischen Materialen, insbesondere aus Silizium-Verbindungen. In diesem Fall lässt sich die gesamte Anti-Reflexbeschichtung durch geeignete Wahl der Reaktivgasanteile in einer einzigen Beschichtungsanlage aufbringen.

In einer weiteren Ausführungsform ist die Dicke der wenigstens einen absorbierenden Schicht so gewählt, dass die auf die absorbierende Schicht auftreffende Strahlung vollständig absorbiert wird. Die Erfinder haben erkannt, dass bei Verwendung eines Spiegelsubstrats aus Silizium sich an der Oberfläche des Spiegelsubstrats eine dünne Schicht aus Siliziumoxid (SiO₂) ausbilden kann, deren Dicke typischer Weise zwischen ca. 0 nm und ca. 7 nm variiert. Diese Siliziumoxid-Schicht sollte bei der Berechnung des Schichtdesigns der Anti-Reflexbeschichtung mit berücksichtigt werden, was aber wegen ihrer variablen Dicke in der Regel nur schwer möglich ist. Daher wird vorgeschlagen, die Dicke der absorbierenden Schicht so groß zu wählen, dass keine Strahlung auf das Spiegelsubstrat bzw. die Siliziumoxid-Schicht mehr auftrifft. Auf diese Weise ist die Berechnung des Designs von der Siliziumoxid-Schicht unabhängig und es bestehen definierte Bedingungen für die Berechnung der Schichtdicken der auf die absorbierende Schicht folgenden weiteren Schichten.

In einer Ausführungsform liegt die Dicke der wenigstens einen absorbierenden Schicht zwischen 40 nm und 100 nm, insbesondere zwischen 60 nm und 80 nm. Bei den für die Mikrospiegelanordnung verwendeten Leistungsdichten und den für die absorbierende Schicht typischer Weise verwendeten Silizium-Stickstoff-Verbindungen genügt eine absorbierende Schicht mit einer solchen Dicke in der Regel, die einfallende Strahlung vollständig zu absorbieren.

In einer weiteren Ausführungsform weist die Anti-Reflexbeschichtung bei einer Nutzwellenlänge von 193 nm oder bei einer Nutzwellenlänge von 248 nm unter senkrechtem Einfall eine Reflektivität von 5 % oder weniger, bevorzugt von 3 % oder weniger, insbesondere von 1 % oder weniger auf. Dies ist eine deutliche Reduzierung der Reflektivität gegenüber einem Spiegelsubstrat z.B. aus Silizium, das bei einer Wellenlänge von 193 nm eine Reflektivität von ca. 65 % aufweist.

In einer Ausführungsform weist die reflektierende Beschichtung, insbesondere das erste Schichtteilsystem, bei einer Nutzwellenlänge von 193 nm oder bei einer Nutzwellenlänge von 248 nm bei einem Einfallswinkel zwischen 0° und 25° zur Normalen der reflektierenden Oberfläche eine Reflektivität von mehr als 65 %, bevorzugt von mehr als 80 %, insbesondere von mehr als 95 % auf. Durch eine solch hohe Reflektivität kann der Nachteil, dass nicht die gesamte Fläche einer Mikrospiegelanordnung das Licht reflektiert, für den Einsatz einer solchen Mikrospiegelanordnung innerhalb eines Beleuchtungssystems für die Mikrolithographie ausgeglichen werden.

In einer weiteren Ausführungsform ist die reflektierende Beschichtung, insbesondere das zweite Schichtteilsystem derart ausgelegt, dass eine Reflektivität von mehr als 65 %, insbesondere von mehr als 85 % bei einer von der Nutzwellenlänge abweichenden Messwellenlänge unter einem Einfallswinkel zur Normalen der reflektierenden Oberfläche (11) resultiert, wobei der Einfallswinkel um mehr als 15°, insbesondere um mehr als 20° von einem Einfallswinkel des Nutzlichtes abweicht und wobei die Einfallswinkel des Nutzlichtes durch die beabsichtigte Nutzung der Mikrospiegelanordnung vorgegeben sind. Hierdurch ist es möglich, die für die Kalibrierung notwendigen Strahlengänge und Optiken entlang anderer, insbesondere geneigter Strahlengänge gegenüber der Mikrospiegelanordnung zu führen, so dass sich die Optiken zur Kalibrierung und die restlichen Optiken des Beleuchtungssystems bauraumtechnisch nicht beeinflussen.

In einer weiteren Ausführungsform weist die Anti-Reflexbeschichtung unter senkrechtem Einfall in einem Wellenlängenbereich zwischen 185 nm und 210 nm, insbesondere bis 230 nm, eine Reflektivität von 10 % oder weniger, bevorzugt von 5 % oder weniger auf. Eine solche breitbandige Entspiegelung kann erreicht werden, indem die Dicken der absorbierenden Schicht und der weiteren Schichten geeignet aufeinander abgestimmt werden Für die Optimierung der Schichtdicken bei bekannten Brechzahlen der verwendeten Schichtmaterialien können konventionelle Schichtdesignprogramme verwendet werden. Vorteile einer Breitbandentspiegelung sind höhere Fertigungstoleranzen und die Abdeckung eines breiteren Bereiches der Einfallswinkel für eine ausgewählte Wellenlänge.

In einer Ausführungsform wird die reflektierende Beschichtung auf die Anti-Reflexbeschichtung zunächst flächig aufgebracht und nachfolgend durch lithographische Verfahren strukturiert, indem die reflektierende Beschichtung in vorgegebenen Bereichen gezielt bis zur Anti-Reflexbeschichtung abgetragen wird. Alternativ oder zusätzlich ist es möglich, die reflektierende Beschichtung zumindest teilweise direkt auf das Spiegelsubstrat aufzubringen, z.B. wenn die Anti-Reflexbeschichtung bereits so strukturiert ist, dass in den Bereichen, in denen die optischen Oberflächen gebildet werden sollen, keine Anti-Reflexbeschichtung vorhanden ist.

In einer weiteren Ausführungsform umfasst die Mikrospiegelanordnung eine Stützstruktur, an welcher der mindestens eine Mikrospiegel beweglich gelagert ist. Die bewegliche Lagerung des in der Regel plattenförmigen Mikrospiegels an der in der Regel säulenförmigen Stützstruktur kann z.B. über ein Scharnier oder über eine Feder erfolgen. Die Auslenkung des Mikrospiegels erfolgt hierbei typischer Weise durch elektrostatische Anziehung des Spiegelsubstrats mit Hilfe von unter dem Mikrospiegel angeordneten Elektroden.

In einer Ausführungsform weist die Mikrospiegelanordnung mindestens eine Haftvermittlungsschicht auf, die zur Haftvermittlung der reflektierenden Beschichtung auf der Anti-Reflexbeschichtung oder zur Haftvermittlung der Anti-Reflexbeschichtung auf dem Substrat dient. Hierdurch wird ein ungewolltes Abplatzen der Schichten vom Substrat vermieden. Abgeplatzte Schichten beeinträchtigen nicht nur den betroffenen Mikrospiegel selbst, sondern können auch benachbarte Mikrospiegel verklemmen.

Ein weiterer Aspekt der Erfindung ist realisiert in einem Verfahren der eingangs genannten Art, umfassend: Beschichten eines Spiegelsubstrats mit der Anti-Reflexbeschichtung, sowie Strukturieren der Anti-Reflexbeschichtung unter Aufbringen einer durch Bestrahlung strukturierbaren Materialschicht auf die Anti-Reflexbeschichtung und/oder auf das Spiegelsubstrat. In einer Ausführungsform besteht das Spiegelsubstrat hierbei aus Silizium.

Erfindungsgemäß wird vorgeschlagen, die Anti-Reflexbeschichtung mit Hilfe eines lithographischen Verfahrens zu strukturieren, d.h. durch Aufbringen einer strahlungsempfindlichen Materialschicht, die durch Bestrahlung strukturiert werden kann. Hierbei kann die Materialschicht auf die Anti-Reflexbeschichtung aufgebracht werden oder direkt auf das Spiegelsubstrat, wobei sie in ersterem Fall als Ätzmaske und in letzterem Fall als Opferschicht oder Ätzstopp dient. In jedem Fall wird die strahlungsempfindliche Materialschicht nach bzw. bei der Strukturierung der Anti-Reflexbeschichtung entfernt, so dass die Anti-Reflexbeschichtung zunächst flächig aufgetragen und nachfolgend gezielt in den Bereichen abgetragen werden kann, in denen keine Anti-Reflexbeschichtung gewünscht ist.

In einer Variante wird das Spiegelsubstrat mit wenigstens einer absorbierenden Schicht aus einem nicht-metallischen Material beschichtet, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist, so dass die Zahl der Schichten und damit die Zahl der Beschichtungsvorgänge gegenüber einer Anti-Reflexbeschichtung aus einem üblichen, aus transparenten Materialien bestehenden Mehrfachschicht-System deutlich reduziert werden kann.

In einer weiteren Variante wird als Material der absorbierenden Schicht eine Verbindung gewählt, die ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}). Diese Verbindungen weisen alle bei der Nutzwellenlänge von 193 nm hohe Absorptionswerte auf.

In einer weiteren Variante wird auf die absorbierende Schicht mindestens eine weitere Schicht mit einem niedrigeren Brechungsindex als dem Brechungsindex der absorbierenden Schicht aufgebracht, um die Strahlung in die absorbierende Schicht einzukoppeln, d.h. die absorbierende Schicht zu entspiegeln. Es versteht sich, dass auf die weitere Schicht auch eine Schicht mit höherem Brechungsindex folgen kann.

In einer Variante besteht diese weitere Schicht aus HfO₂, MgF₂, LaF₃, Chiolith, Kryolith, Al₂O₃, ErF₃ oder einer Silizium-Sauerstoff-Verbindung, insbesondere aus Siliziumdioxid (SiO₂).

Eine Variante des Verfahrens umfasst das Aufbringen einer reflektierenden Beschichtung auf die Anti-Reflexbeschichtung und/oder auf das Spiegelsubstrat zur Erzeugung mindestens einer reflektierenden Oberfläche an einem Mikrospiegel. Die reflektierende Beschichtung besteht hierbei aus einem erfindungsgemäßen, reflektierenden Mehrfachschicht-System, welches ein erstes und eine zweites Schichtteilsystem umfasst, wobei das erste Schichtteilsystem aus alternierenden hoch- bzw. niedrig brechenden, transparenten Schichten besteht.

Bei einer weiteren Variante wird die reflektierende Beschichtung zunächst flächig aufgebracht und nachfolgend selektiv außerhalb der reflektierenden Oberfläche von der Anti-Reflexbeschichtung entfernt, wobei auch in diesem Fall eine strahlungsempfindliche, strukturierbare Materialschicht im Bereich der reflektierenden Oberfläche als Ätzmaske auf die reflektierende Beschichtung und/oder außerhalb der reflektierenden Oberfläche als Opferschicht bzw. als Ätzstopp auf die Anti-Reflexbeschichtung aufgebracht werden kann.

In einer weiteren Variante wird die Schichtspannung der Anti-Reflexbeschichtung so auf die Schichtspannung der reflektierenden Beschichtung abgestimmt, dass die beiden Schichtspannungen sich im Wesentlichen kompensieren, d.h. eine z.B. negative Schichtspannung der Anti-Reflexbeschichtung kann durch eine betragsmäßig im Wesentlichen gleich große positive Schichtspannung der reflektierenden Beschichtung ausgeglichen werden und umgekehrt. Unter einer Kompensation "im Wesentlichen" wird verstanden, dass die Abweichung des Absolutbetrags der Schichtspannungen der beiden Beschichtungen bei ca. 20 % oder weniger liegt.

In einer Variante wird die Anti-Reflexbeschichtung zunächst flächig auf das Spiegelsubstrat aufgebracht und nachfolgend selektiv im Bereich der reflektierenden Oberfläche von dem Spiegelsubstrat entfernt. Auf diese Weise kann die reflektierende Beschichtung im Bereich der reflektierenden Oberfläche direkt auf das Spiegelsubstrat aufgebracht werden, so dass das Spiegelsubstrat, das von sich aus (z.B. im Falle von Silizium) bereits eine hohe Reflektivität für die einfallende Strahlung aufweist, nur noch durch eine geringe Anzahl von reflektierenden Schichten ergänzt werden muss, um die gewünschte hohe Reflektivität für die einfallende Strahlung im Bereich der reflektierenden Oberfläche zu erhalten.

In einer weiteren Variante wird mindestens eine, bevorzugt jede Schicht der Anti-Reflexbeschichtung durch plasmaunterstützte chemische Gasphasenabscheidung aufgebracht. Insbesondere bei ausschließlicher Verwendung von Silizium-Verbindungen als Materialien für die Schichten der Anti-Reflexbeschichtung kann die Anti-Reflexbeschichtung in einer Beschichtungsanlage in einem einzigen Beschichtungsvorgang aufgebracht werden, indem die Reaktivgasanteile geeignet variiert werden.

In einer Variante weist die reflektierende Beschichtung wenigstens zwei Schichtteilsysteme auf, wobei das erste Schichtteilsystem Schichten aus einer periodischen Abfolge alternierender hoch und niedrig brechender Schichten aus einem nicht-metallischen Material aufweist und bezüglich einer Nutzwellenlänge der Mikrospiegelanordnung im Hinblick auf die Reflektivität optimiert ist und wobei das zweite Schichtteilsystem bezüglich einer von der Nutzwellenlänge abweichenden Messwellenlänge der Mikrospiegelanordnung im Hinblick auf die Reflektivität optimiert ist, wobei die reflektierende Beschichtung mindestens eine Trennschicht zwischen den zwei Schichtteilsystemen aufweist und das Material der Trennschicht ein Material ist, das ausgewählt ist aus der Gruppe umfassend: TiO₂, Ta₂O₅, HfO₂, ZrO₂, Si, Ge, ZnS, CuInSe₂, CuInS₂, La₂O₃, wobei die Materialien der Schichten des ersten Schichtteilsystems Materialien sind, welche ausgewählt sind aus der Gruppe umfassend: LaF₃, MgF₂, SiO₂, Al₂O₃, ErF₃, GdF₃, HfO₂, AlF₃ und wobei die Materialien der Schichten des zweiten Schichtteilsystems Materialien sind, welche ausgewählt sind aus der Gruppe umfassend: La₂O₃, ZrO₂, TiO₂, Ta₂O₅, MgF₂, SiO₂, Al₂O₃, Si, Ge, HfO₂, AlF₃.

Weitere Merkmale und Vorteile der Erfindung ergeben sich aus der nachfolgenden Beschreibung von Ausführungsbeispielen der Erfindung, anhand der Figuren, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Figuren

Ausführungsbeispiele sind in den schematischen Figuren dargestellt und werden in der nachfolgenden Beschreibung erläutert. Es zeigt:
- **Fig. 1a**: eine schematische Darstellung einer erfindungsgemäßen Mikrospiegelanordnung in einer Draufsicht,
- **Fig. 1b**: die Mikrospiegelanordnung von Fig. 1a in einer Schnittdarstellung nach dem Beschichten und vor dem Strukturieren der Anti-Reflexbeschichtung mittels einer strahlungsempfindlichen, strukturierten Materialschicht, sowie
- **Fig. 1c**: die Mikrospiegelanordnung von Fig. 1 b nach dem Strukturieren der Anti-Reflexbeschichtung und nach dem Entfernen der strahlungsempfindlichen Materialschicht,
- **Fign. 2a-c**: eine schematische Darstellung einer ersten Variante der Beschichtung der Mikrospiegelanordnung von Fig. 1a mit einer Anti-Reflexbeschichtung und einer reflektierenden Beschichtung,
- **Fign. 3a-c**: eine schematische Darstellung einer zweiten Variante der Beschichtung der Mikrospiegelanordnung von Fig. 1a,
- **Fig. 4a-c**: eine schematische Darstellung einer dritten Variante der Beschichtung der Mikrospiegelanordnung von Fig. 1a,
- **Fig. 5**: eine Darstellung der Reflektivität einer ersten Variante der Anti-Reflex-beschichtung in Abhängigkeit vom Einfallswinkel,
- **Fig. 6**: eine Darstellung der Reflektivität einer zweiten Variante der Anti-Reflexbeschichtung in Abhängigkeit vom Einfallswinkel und von der Dicke einer auf dem Spiegelsubstrat gebildeten Siliziumoxidschicht,
- **Fig. 7**: eine Darstellung der Reflektivität eines zweiten Ausführungsbeispiels zur zweiten Variante der Anti-Reflexbeschichtung in Abhängigkeit von der Wellenlänge,
- **Fig. 8**: eine schematische Darstellung des Schichtaufbaus eines Ausführungsbeispiels zu der Beschichtung der Mikrospiegelanordnung von Fig. 1a,
- **Fig. 9**: eine Darstellung der Reflektivität des Ausführungsbeispiels von Fig. 8 in Abhängigkeit von der Nutzwellenlänge,
- **Fig. 10**: eine Darstellung der Reflektivität des Ausführungsbeispiels von Fig. 8 in Abhängigkeit von der Messwellenlänge und
- **Fig. 11**: eine schematische Darstellung des Schichtaufbaus der Ausführungsbeispiele zu der Beschichtung der Mikrospiegelanordnung von Fig. 1a.

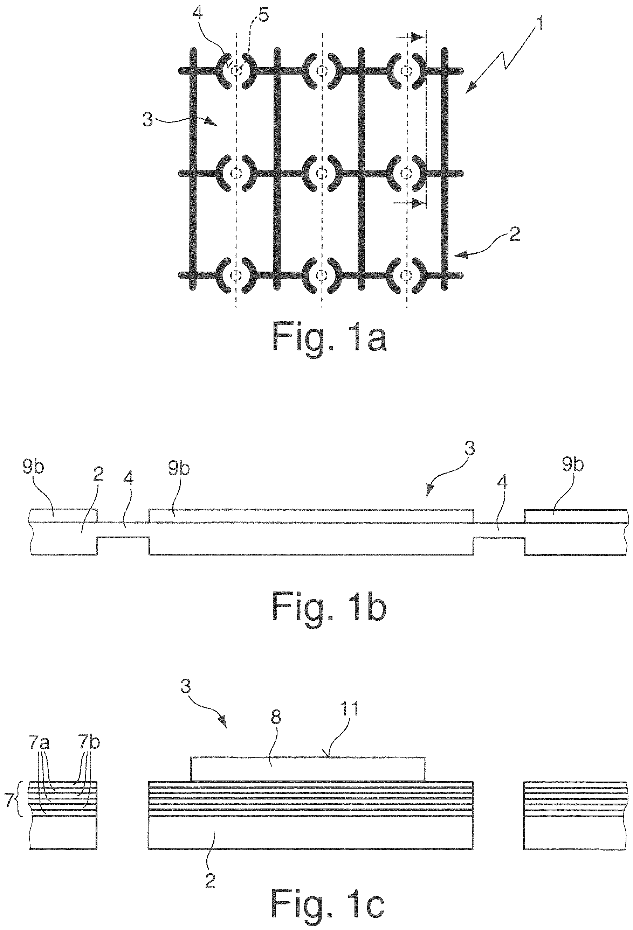

In **Fig. 1a** ist schematisch eine Mikrospiegelanordnung **1** gezeigt, die ein plattenförmiges Spiegelsubstrat **2** aufweist, an dem eine Mehrzahl von Mikrospiegeln **3** zwischen als Scharnieren dienenden Teilbereichen **4** des Spiegelsubstrats 2 mit verringerter Dicke an säulenförmigen Stützstrukturen **5** beweglich gelagert ist. Unterhalb des Spiegelsubstrats 2 sind im Bereich jedes Mikrospiegels 3 mehrere, typischer weise drei (nicht gezeigte) Elektroden angebracht, durch die sich die Mikrospiegel 3 gegenüber einer jeweiligen, gestrichelt angedeuteten Achse verkippen lassen, die im Bereich der Stützstrukturen 5 durch das Spiegelsubstrat 2 verläuft. Es versteht sich, dass die Mikrospiegel 3 auch um zwei z.B. zueinander senkrechte Achsen verkippt werden können, wenn die Anordnung bzw. Formgebung der Scharniere 4 geeignet modifiziert wird, z.B. wenn diese in den Eckbereichen der Mikrospiegel 3 angeordnet werden.

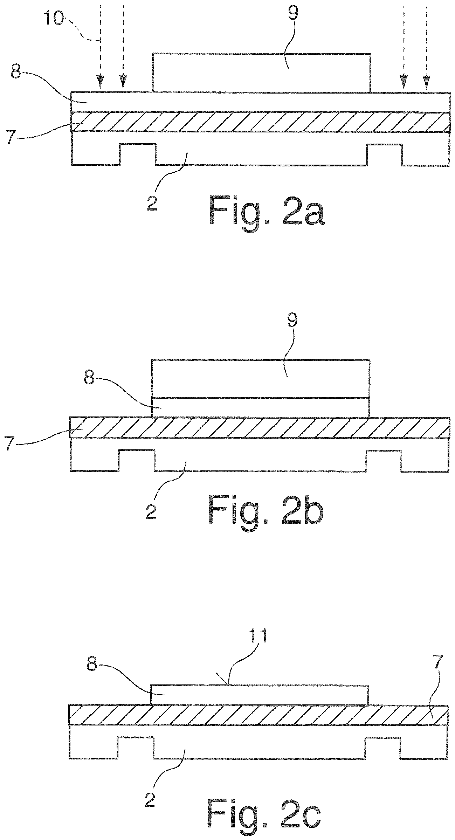

Um die in Fig. 1 a gezeigte Mikrospiegelanordnung 1 zu erhalten, wird auf das noch unstrukturierte, plane Spiegelsubstrat 2 eine Anti-Reflexbeschichtung 7 sowie eine reflektierende Beschichtung **8** aufgebracht, wie nachfolgend anhand der **Fign. 2a****-c,** **Fign. 3a****-c** und **Fign. 4a****-c** näher erläutert wird, welche unterschiedliche Varianten des Beschichtungsvorgangs zeigen.

In Fig. 2a ist eine Beschichtungs-Variante dargestellt, bei der auf das Spiegelsubstrat 2 die Anti-Reflexbeschichtung 7 und auf diese die reflektierende Beschichtung 8 flächig aufgebracht ist. Auf die reflektierende Beschichtung 8 ist eine strahlungsempfindliche Materialschicht 9 aufgebracht, im Folgenden auch Resist genannt, die in einem vorausgehenden Schritt durch Bestrahlung bzw. Belichtung und anschließendes Entwickeln strukturiert und nachfolgend in den unbelichteten Bereichen entfernt wurde. Die Materialschicht 9 kann hierbei aus den in der Mikrolithographie üblichen Resist-Materialien bestehen, welche selektiv abgetragen werden können, so dass die reflektierende Beschichtung 8 beim teilweisen Abtrag der Materialschicht 9 intakt bleibt.

Wie ebenfalls in Fig. 2a gezeigt ist, wird nachfolgend die reflektierende Beschichtung 8 selektiv in den Bereichen durch einen Ätzprozess abgetragen, an denen keine strukturierte Materialschicht 9 vorhanden ist. Der Ätzangriff ist hierbei durch gestrichelte Pfeile **10** angedeutet und kann mittels trockenem oder nassem Ätzen auf bekannte Weise durchgeführt werden. Durch das Ätzen erfolgt ein vollständiger Abtrag der reflektierenden Beschichtung 8 in den nicht durch den Resist 9 geschützten Bereichen, wie in Fig. 2b dargestellt ist, d.h. der Resist 9 dient als Ätzmaske für die Strukturierung der reflektierenden Beschichtung 8. In Fig. 2c wird das Ergebnis der Beschichtung dargestellt, nachdem der Resist 9 von der reflektierenden Beschichtung 8 entfernt wurde, wodurch eine reflektierende Oberfläche **11** mit der gewünschten Geometrie an der reflektierenden Beschichtung 8 gebildet wird.

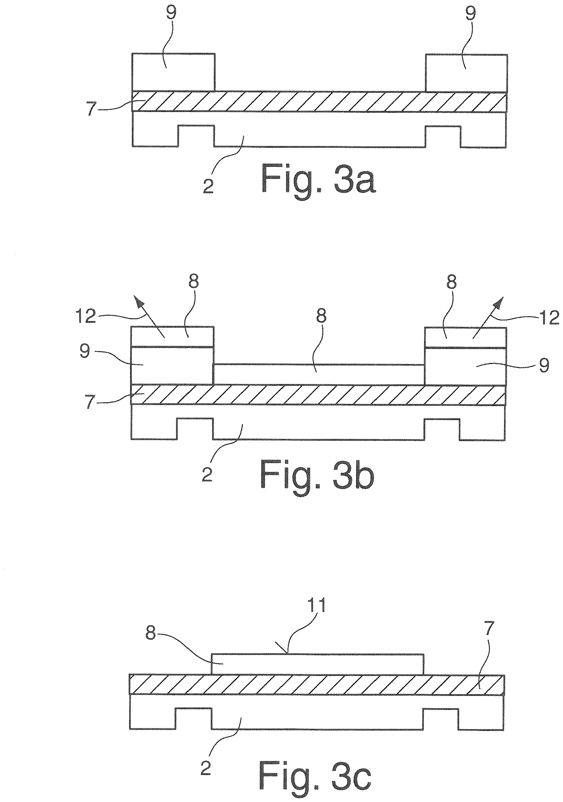

Der in Fign. 3a-c dargestellte Beschichtungsprozess unterscheidet sich von dem der Fign. 2a-c gezeigten dadurch, dass vor dem Aufbringen der reflektierenden Beschichtung 8 auf die Anti-Reflexbeschichtung 7 zunächst der Resist 9 aufgebracht und strukturiert wird, vgl. Fig. 3a. Der Resist 9 dient hierbei als Opferschicht und kann wie in Fig. 3b durch Pfeile **12** angedeutet ist, mittels geeigneter, ebenfalls bekannter Verfahren von der Anti-Reflexbeschichtung 7 abgehoben werden, nachdem auf diese die reflektierende Beschichtung 8 aufgebracht wurde. Wie in Fig. 3c gezeigt, bleibt auf diese Weise ebenfalls nur der gewünschte Bereich der reflektierenden Beschichtung 8 mit der reflektierenden Oberfläche 11 auf der Anti-Reflexbeschichtung 7 zurück.

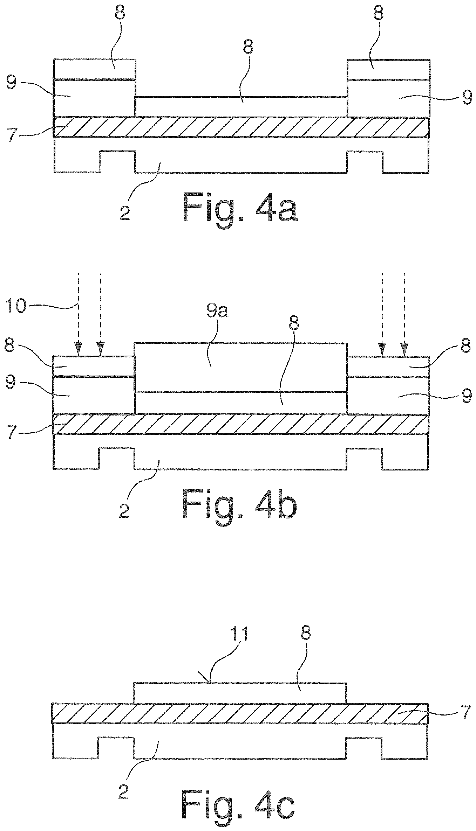

Fign. 4a-c zeigen schließlich eine Variante des Verfahrens, bei denen die Beschichtungsschritte der Fign. 2a-c und Fign. 3a-c kombiniert werden. Ausgangspunkt ist hierbei die in Fig. 3b dargestellte Situation, bei der auf den strukturierten Resist 9 die reflektierende Beschichtung 8 aufgebracht wurde. In diesem Fall wurde aber ein Resist-Material gewählt, das nicht als Opferschicht, sondern als Ätzstopp für die darunter liegende Anti-Reflexbeschichtung 7 dient. Wie in Fig. 4b dargestellt, wird auf den Teilbereich der reflektierenden Beschichtung 8, welcher unmittelbar auf die Anti-Reflexbeschichtung 7 aufgebracht wurde, eine weitere Resist-Schicht **9a** als Ätzstopp aufgebracht und strukturiert, so dass der nicht von der Resist-Schicht 9a bedeckte Teil der reflektierenden Beschichtung 9 in einem nachfolgenden Ätzschritt abgetragen werden kann, wie in Fig. 4b durch Pfeile 10 dargestellt ist, wobei das Ätzen an dem Resist 9 gestoppt wird. Nach dem Abtragen des Resists 9 und der Resist-Schicht 9a wird ebenfalls die reflektierende Oberfläche 11 mit der gewünschten Form auf der Anti-Reflexbeschichtung 7 erhalten, wie in Fig. 4c gezeigt ist.

Die beiden in Fig. 3a-c und Fig. 4a-c gezeigten Varianten bieten sich an, wenn die reflektierende Beschichtung 8 nicht selektiv bezüglich der Anti-Reflexbeschichtung 7 geätzt werden kann. Bei den oben beschriebenen Beschichtungsvarianten können die einzelnen Schichten jeweils durch übliche Dünnschicht-Beschichtungsverfahren, z.B. durch plasmaunterstützte chemische Gasphasenabscheidung (PECVD), durch thermisches Verdampfen oder durch Sputtern aufgebracht werden.

Neben den in Fign. 2a-c bis 4a-c gezeigten Beschichtungsvarianten ist es auch möglich, zunächst die Anti-Reflexbeschichtung 7 zu strukturieren und in den Bereichen gezielt abzutragen, in denen die reflektierende Beschichtung 8 bzw. die optische Oberfläche 11 gebildet werden soll. Auf diese Weise kann die reflektierende Beschichtung 8 unmittelbar auf das Spiegelsubstrat 2 aufgebracht werden, so dass dessen hohe Reflektivität beim Design der reflektiven Beschichtung berücksichtigt und genutzt werden kann.

In jedem Fall wird nachfolgend auf das Substrat 3 eine weitere Resistschicht **9b** flächig aufgebracht, die in den als Scharniere dienenden Teilbereichen 4 strukturiert ist, wie in **Fig. 1b** dargestellt, in der auf die Darstellung Anti-Reflexbeschichtung sowie die reflektierenden Beschichtung der besseren Übersicht halber verzichtet wurde. Die in Fig. 1b gezeigte Darstellung folgt hierbei der in Fig. 1a gezeigten Schnittlinie vor der Strukturierung des Substrats 2. In einem nachfolgenden Ätzschritt werden in den Teilbereichen 4 Durchbrüche gebildet, wie in **Fig. 1c** gezeigt ist, in der die Mikrospiegelanordnung 1 entlang der Schnittlinie von Fig. 1a im Endzustand nach dem Entfernen der Resistschicht 9b dargestellt ist.

In Fig. 1c ist außerdem der Aufbau der Anti-Reflexbeschichtung 7 genauer gezeigt: Diese weist eine erste, absorbierende Schicht **7a** auf, auf die eine weitere Schicht **7b** aufgebracht ist, die zum Einkoppeln der auf die Anti-Reflexbeschichtung 7 auftreffenden, (nicht gezeigten) Strahlung in die absorbierende Schicht 7a dient und deren Brechungsindex geringer ist als derjenige der absorbierenden Schicht 7a. Auf das erste Schichtenpaar 7a, 7b folgen noch zwei weitere, identische Schichtenpaare 7a, 7b. Die absorbierende Schicht 7a besteht im vorliegenden Fall aus Silizium-Nitrid (SiN), welches in Abhängigkeit von der gewählten Prozessführung einen Realteil des Brechungsindex n zwischen ca. 2,20 und 2,65 und einen Imaginärteil k (Absorptionskoeffizienten) zwischen 0,17 und 0,7 bei einer Wellenlänge von 193 nm aufweist. Die weitere Schicht 7b besteht hierbei aus SiO₂, das einen Brechungsindex n zwischen 1,56 und 1,70 und einen Absorptionskoeffizienten k zwischen 0,0002 und 0,015 aufweist.

Wie aus Fig. 1c ebenfalls zu ersehen ist, wird ca. 50 % der Fläche der Mikrospiegelanordnung 1 zur gezielten Umlenkung der einfallenden Strahlung an den reflektierenden Oberflächen 11 verwendet. Außerhalb der reflektierenden Oberflächen 11 trifft noch ca. 1 % der gesamten Intensität der einfallenden Strahlung auf, von denen maximal 10 % reflektiert werden dürfen, wenn die Mikrospiegelanordnung 1 zur Pupillenformung verwendet werden soll, da in diesem Fall die nicht gezielt reflektierte Strahlung direkt in die Pupille gelangt. Da das Spiegelsubstrat 2 aus Silizium eine Reflektivität von ca. 65 % aufweist, muss eine Anti-Reflexbeschichtung 7 so ausgelegt sein, dass die Reflektivität um ca. 55 - 60 % reduziert wird.

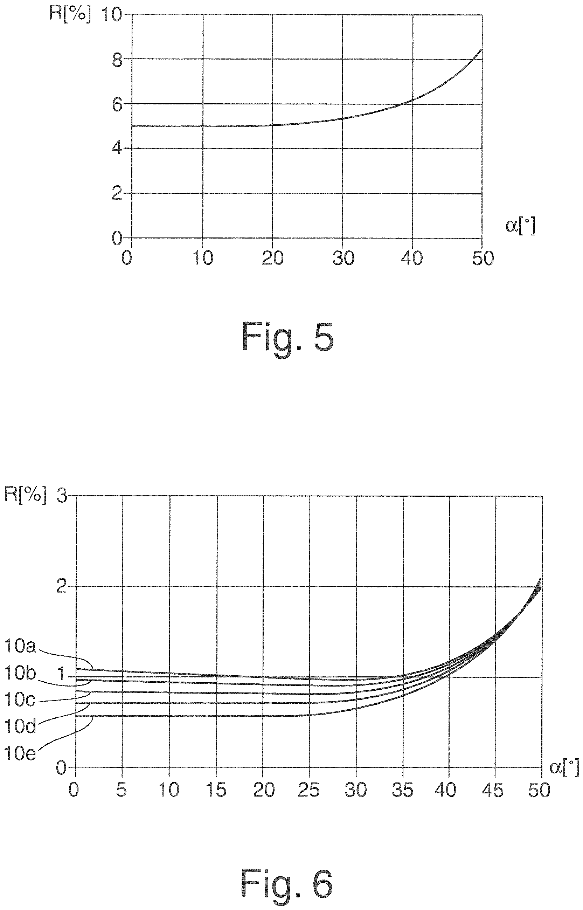

Ein typisches Schichtdesign (6-Schichter) für die Anti-Reflexbeschichtung 7, das eine Reflektivität **R** von weniger als 10 % auch bei hohen Inzidenzwinkeln α von 50° und darüber aufweist, ist in **Fig. 5** gezeigt, wobei die Schichtdicken gegeben sind durch: (Si-Substrat) 3x(2,9nm H 1,95nm L) (physikalische Dicke jeweils in Nanometern) und für die einzelnen Schichten folgende Daten zu Grunde gelegt wurden:

| | | n | k |
|---|---|---|---|
| Silizium-Substrat: | | 0,88 | 2,78 |
| SiN: | H | 2,5 | 0,3 |
| SiO₂: | L | 1,56 | 0,0002 |

Es versteht sich, dass sich durch Anpassung der Dicken der Schichten 7a, 7b bzw. der Anzahl der verwendeten Schichten die Reflektivität geeignet anpassen, insbesondere weiter verringern lässt, wobei für die Entspiegelung des nicht transparenten Siliziums die vergleichsweise hohe Absorption (Absorptionskoeffizient größer 0,1) von Silizium-Nitrid als absorbierendem Schichtmaterial günstig ist. Es versteht sich, dass auch andere Schichtmaterialien für die Anti-Reflexbeschichtung 7 in Frage kommen, z.B. Silizium-Nitride anderer Zusammensetzung (SiₓN_{y}) bzw. Silizium-Oxid-Nitride (SiOₓN_{y}), wobei die Anzahl und Reihenfolge der aufgebrachten Schichten von der zu erzielenden Reflektivität und dem Inzidenzwinkelbereich abhängig ist, unter dem die Strahlung auf die Mikrospiegelanordnung 1 einfällt.

Bei der ausschließlichen Verwendung der oben erwähnten, Silizium enthaltenden Materialien für die Schichten der Anti-Reflexbeschichtung 7 können alle Schichten in derselben Beschichtungsanlage aufgebracht werden, indem die Reaktivgasanteile in der Anlage geeignet eingestellt werden. Es versteht sich, dass auch Schichten aus anderen Materialien, mit denen sich die gewünschte Reflektivität erzielen lässt, in der Anti-Reflexbeschichtung Verwendung finden können. Insbesondere können als absorbierende Schichten ggf. auch Metalle wie Aluminium, Chrom oder Titan eingesetzt werden. Auch für die weitere Schicht 7b können andere Materialien als Siliziumoxid (SiO₂) verwendet werden, die für die einfallende Strahlung im Wesentlichen transparent sind und einen Brechungsindex aufweisen, der unter dem Brechungsindex der absorbierenden Schicht 7a liegt.

Bei dem im Zusammenhang mit Fig. 5 beschriebenen Beispiel für eine Anti-Reflexbeschichtung ist die Schichtdicke der absorbierenden Schicht 7a nicht groß genug, um die einfallende Strahlung vollständig zu absorbieren. Demzufolge muss das Spiegelsubstrat 2 bei der Berechnung des Schichtdesigns berücksichtigt werden. In der Regel bildet sich jedoch an der Oberfläche des Spiegelsubstrats eine dünne Schicht aus Siliziumoxid (maximal 7 nm) aus, wobei die Dicke ortsabhängig sein kann und auch in Abhängigkeit vom Herstellungsprozess des Spiegelsubstrats variiert. Da die Dicke der Oxidschicht in der Regel bei der Berechnung des Designs nicht genau bekannt ist, ist es schwierig, ein Design mit den gewünschten Eigenschaften zu erzeugen. Daher ist es vorteilhaft, die reflektierende Schicht 7a der Anti-Reflexbeschichtung mit einer solchen Dicke zu versehen, dass die einfallende Strahlung nicht oder nur in geringem Umfang bis zum Spiegelsubstrat 2 bzw. zu der oxidischen Schicht gelangt, so dass diese für die Wirkung der Entspiegelung unerheblich bleibt. Je nach Zielwert für die Restreflexion liegt bei Silizium-Nitrid als absorbierender Schicht die hierfür benötigte Dicke zwischen einigen 10 nm und über 100 nm. Die benötigte Dicke hängt vom Absorptionskoeffizienten und damit auch vom Herstellungsprozess der Silizium-NitridSchicht ab.

**Fig. 6** zeigt ein Beispiel für die Reflektivität R eines Schichtdesigns (2-Schichters) mit einer Reflexion von ca. ≤1% bei senkrechtem Einfall und einer Wellenlänge von 193 nm. Das Design weist folgende physikalische Schichtdicken auf: (Si-Substrat) (0 bis 7nm N) (97.9nm H) (28.5nm L)

Für die einzelnen Schichten wurden folgende Daten zu Grunde gelegt:

| Brechzahl | n | k |
|---|---|---|
| Substrat Si | 0,88 | 2,78 |
| N Nat. SiO2 | 1,56 | 0,0002 |
| H PECVD SiN | 2,38 | 0,44 |
| L PECVD Si02 | 1,66 | 0,0005 |

Die in Fig. 6 dargestellten Reflektivitätskurven **10a** bis **10e** wurden hierbei für folgende Dicken der Siliziumoxidschicht im Bereich zwischen 0 nm und 7 nm ermittelt: Kurve 10a: 0 nm, 10b: 1 nm, 10c: 3 nm, 10d: 5 nm, 10e: 7 nm. Wie deutlich zu erkennen ist, nimmt die Reflektivität R mit zunehmender Schichtdicke der nativen SiO₂-Schicht ab, die Dicke der absorbierenden Schicht 7a von ca. 100 nm ist aber ausreichend, um bei allen betrachteten Fällen eine Reflektivität R zu erreichen, die bei senkrechtem Einfall im Bereich um ca. 1 % und darunter liegt. Bei diesem Design ist abweichend von dem in Fig. 1 c dargestellten Fall somit ein einziges Schichtenpaar 7a, 7b ausreichend, um die gewünschte Reflektivität R zu erzielen.

Zusätzlich zur Entspiegelung bei einer einzelnen Wellenlänge, z.B. bei 193 nm, ist es auch möglich, eine Entspiegelung über einen Wellenlängenbereich z.B. zwischen 185 nm und 230 nm zu realisieren. In diesem Fall muss das optische Design bzw. müssen die Schichtdicken der Schichten 7a, 7b und ggf. weiterer Schichten entsprechend angepasst werden Für die Optimierung der Schichtdicken bei bekannten Brechzahlen der verwendeten Schichtmaterialien werden typischerweise handelsübliche Schichtdesignprogramme verwendet. Vorteile einer Breitband-Entspiegelung sind höhere Fertigungstoleranzen und die Abdeckung eines breiteren Bereiches der Einfallswinkel für eine ausgewählte Wellenlänge.

Bei der in Fig. 1 c dargestellten Konfiguration, bei der die reflektierende Beschichtung 8 auf die Anti-Reflexbeschichtung 7 aufgebracht ist, ist es möglich, die Schichtspannung der Anti-Reflexbeschichtung so auf die Schichtspannung der reflektierenden Beschichtung abzustimmen, dass die beiden Schichtspannungen sich im Wesentlichen kompensieren, d.h. eine resultierende positive Schichtspannung der einen Beschichtung kann durch eine betragsmäßig im Wesentlichen gleich große (Abweichung maximal ca. 20 %) negative Schichtspannung der anderen Beschichtung kompensiert werden. Hierbei kann ausgenutzt werden, dass die Schichtspannungen der einzelnen Schichten, insbesondere der absorbierenden Schicht 7a (z.B. aus SiN) in Abhängigkeit vom gewählten Beschichtungsverfahren bzw. der gewählten Beschichtungsparameter variiert, so dass die Schichtspannung der Anti-Reflexbeschichtung geeignet angepasst werden kann.

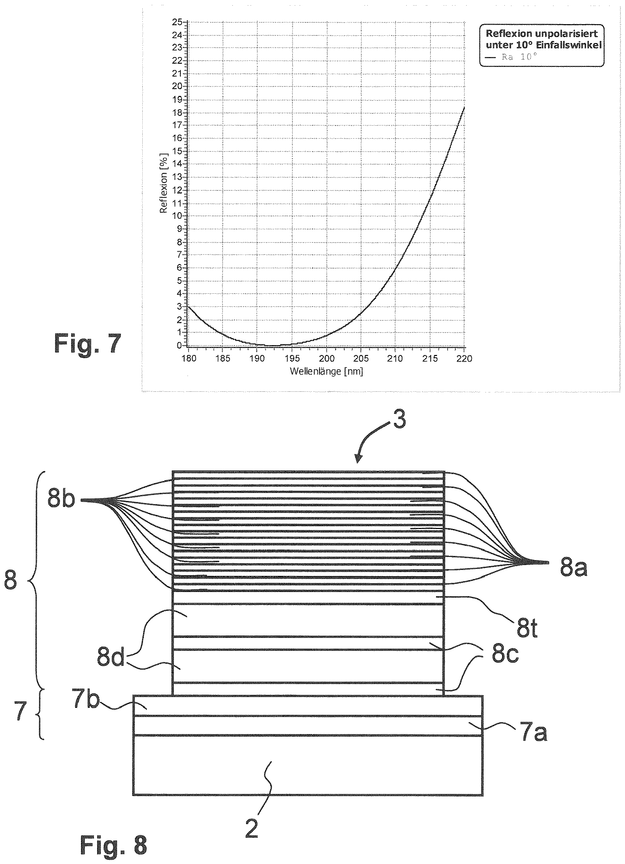

**Fig. 7** zeigt die Reflektivität eines zweiten Ausführungsbeispiels zur zweiten Variante der Anti-Reflexbeschichtung 7 gemäß Fig. 6 in Abhängigkeit von der Wellenlänge. Die Reflektion dieser Anti-Reflexbeschichtung 7 liegt bei der Nutzwellenlänge von 193 nm bei senkrechtem Einfall des Nutzlichtes der Mikrospiegelanordnung unter 1 %. Das Design weist folgende physikalische Schichtdicken auf: (Si-Substrat) (90.2nm H) (85.8nm L).

Für die einzelnen Schichten wurden hierbei die Daten gemäß den Ausführungsbeispielen zu Fig. 6 zu Grunde gelegt, wobei die Beschichtung des Ausführungsbeispiels zu Fig. 7 direkt auf dem Si-Spiegelsubstrat aufgebracht ist und nicht durch eine SiO₂-Schicht von diesem getrennt ist. Die absorbierende Schicht **7a** besteht somit aus SiN und die weitere Schicht **7b,** welche zum Einkoppeln der auf die Anti-Reflexbeschichtung 7 auftreffenden Strahlung aufgebracht ist, besteht aus SiO₂.

Es ist anhand von Fig. 7 zu erkennen, dass die zugehörige Anti-Reflexbeschichtung 7 in der Lage ist, bis zu einer Nutzwellenlänge von 212 nm dafür zu sorgen, dass die Reflektivität der Bereiche außerhalb der reflektiven Oberflächen 11 einer Mikrospiegelanordnung unter 10 % bleibt.

**Fig. 8** ist eine schematische Darstellung des Schichtaufbaus eines Ausführungsbeispiels zu der Beschichtung eines Mikrospiegels 3 der Mikrospiegelanordnung von Fig. 1a, welches neben der Anti-Reflexbeschichtung 7 mit den Schichten 7 a und 7b auf einem Substrat 2 auch die reflektierende Beschichtung 8 mit umfasst. Die reflektierende Beschichtung 8 besteht hierbei aus zwei Schichtteilsysteme, wobei das erste Schichtteilsystem Schichten 8a, 8b aus einer periodischen Abfolge alternierender hoch und niedrig brechender Schichten aus einem nicht-metallischen Material aufweist und bezüglich der Nutzwellenlänge von 193 nm im Hinblick auf die Reflektivität optimiert ist. Das zweite Schichtteilsystem besteht aus den hoch und niedrig brechenden Schichten 8c, 8d und ist bezüglich der Messwellenlänge von 633 nm im Hinblick auf die Reflektivität optimiert. Das konkrete Schichtdesign für dieses Ausführungsbeispiel lässt sich wie folgt angeben:
(Si-Substrat) (4,288 SiN)(2,783 SiO₂) 2x(1,796 TiO₂ 4,170 MgF₂) (1,796 TiO₂) 9x(1 MgF₂ 1 LaF₃).

Dabei beziehen sich die Zahlenangaben auf die Einheit Quarter Wave Optical Thickness (QWOT), also auf ein Viertel der Wellenlänge, bei der Nutzwellenlänge von 193 nm bei nahezu senkrechtem Einfall. Das Ausführungsbeispiel zu Fig. 8 umfasst somit eine Anti-Reflexbeschichtung 7 gemäß Fig. 7, ein zweites reflektierendes Schichtteilsystem aus zwei Perioden von Schichten 8c aus TiO₂ und Schichten 8d aus MgF₂ für die Wellenlänge 633 nm, eine Trennschicht 8t aus TiO₂ und ein erstes Schichtteilsystem aus 9 Perioden von Schichten 8b aus MgF₂ und 8a aus LaF₃ für die Wellenlänge 193 nm. Statt einer Trennschicht aus TiO₂ zwischen dem ersten und dem zweiten Schichtteilsystem hätten hierbei auch Schichten aus den Materialien ZrO₂, Ta₂O₅, HfO₂, Si, Ge, ZnS, CuInSe₂ oder CuInS₂ gewählt werden können. Die Trennschicht dient dazu, die Reflektionseigenschaften des ersten Schichtteilsystems von dem darunter liegenden Schichtteilsystem zu entkoppeln, indem es dafür sorgt, dass möglichst wenig Licht der Nutzwellenlänge die Trennschicht zu dem darunterliegenden Schichtteilsystem passiert. Ferner kann eine zusätzliche Haftvermittlungsschicht zwischen der Anti-Reflexbeschichtung 7 und dem Substrat 2 und/ oder zwischen der Anti-Reflexbeschichtung 7 und der reflektierenden Beschichtung 8 beim Ausführungsbeispiel zu Figur 8 vorgesehen werden.

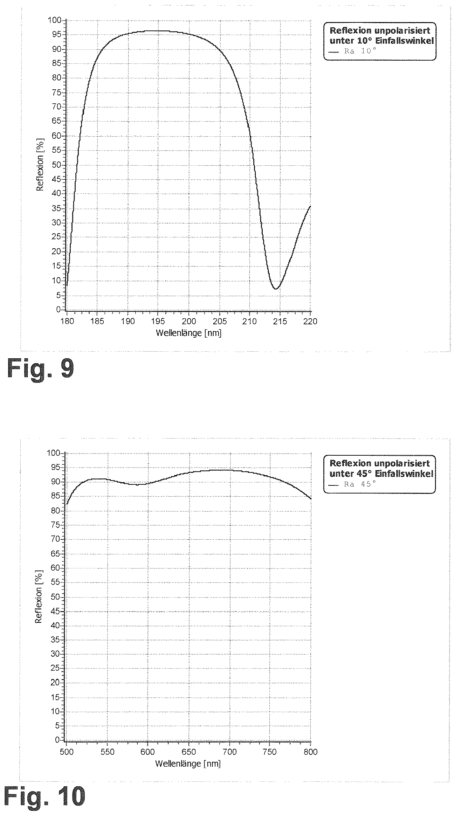

Die Reflektionseigenschaften dieses Ausführungsbeispiels außerhalb der reflektierenden Oberfläche 11 wurden schon anhand der Figur 7 diskutiert. Die Reflektionseigenschaften innerhalb der reflektierenden Oberfläche 11 eines Mikrospiegels 3 mit einer Beschichtung gemäß dem Ausführungsbeispiel zu Figur 8 werden nachfolgend anhand der Figuren 9 und 10 diskutiert.

**Fig. 9** zeigt eine Darstellung der Reflektivität des Ausführungsbeispiels von Fig. 8 in Abhängigkeit von der Wellenlänge in der Umgebung der Nutzwellenlänge von 193 nm. Es ist anhand Figur 8 zu erkennen, dass das Ausführungsbeispiel zu Figur 8 eine Reflektivität von über 95 % bei der Nutzwellenlänge von 193 nm bei einem Einfallswinkel von 10° gegenüber der Normalen der reflektierenden Oberfläche 11 des Mikrospiegels 3 aufweist. Ferner ist zu erkennen, dass die Reflektivität bei einer Nutzwellenlänge zwischen 185 nm und 205 nm bei einem Einfallswinkel von 10° dieses Ausführungsbeispiels über 85 % beträgt.

**Fig. 10** zeigt eine Darstellung der Reflektivität des Ausführungsbeispiels von Fig. 8 in Abhängigkeit von der Wellenlänge in der Umgebung der Messwellenlänge von 633 nm der Mikrospiegelanordnung. Es ist anhand von Fig. 10 zu erkennen, dass das Ausführungsbeispiel zu Figur 8 eine Reflektivität von über 90 % bei der Messwellenlänge von 633 nm bei einem Einfallswinkel von 45° gegenüber der Normalen der reflektierenden Oberfläche 11 des Mikrospiegels 3 aufweist. Darüber hinaus ist zu erkennen, dass die Reflektivität dieses Ausführungsbeispiels gleichzeitig zu der Reflektivität bei der Nutzwellenlänge, welche in Fig. 9 dargestellt ist, bei einer Messwellenlänge zwischen 500 nm und 800 nm und bei einem Einfallswinkel von 45° mehr als 80 % beträgt. Somit ist die reflektierende Beschichtung 8, insbesondere das zweite Schichtteilsystem derart ausgelegt, dass eine Reflektivität von mehr als 65 %, insbesondere von mehr als 80 % bei einer von der Nutzwellenlänge abweichenden Messwellenlänge unter einem Einfallswinkel zur Normalen der reflektierenden Oberfläche 11 resultiert, wobei der Einfallswinkel um mehr als 15°, insbesondere um mehr als 20° von einem Einfallswinkel des Nutzlichtes abweicht und wobei die Einfallswinkel des Nutzlichtes durch die beabsichtigte Nutzung der Mikrospiegelanordnung vorgegeben sind.

Es versteht sich, dass die Anti-Reflexbeschichtung nicht zwingend auf der Oberseite des Spiegelsubstrats 2 aufgebracht werden muss, sondern dass bei geeigneter Geometrie der Mikrospiegelanordnung auch eine Anbringung der Anti-Reflexbeschichtung an der Rückseite des Spiegelsubstrats 2 oder an einem darunter liegenden Substrat, das ggf. ebenfalls aus Silizium besteht, aufgebracht werden kann, wie in der eingangs zitierten US 6,891,655 B2 dargestellt ist, welche bezüglich dieses Aspekts durch Bezugnahme zum Inhalt dieser Anmeldung gemacht wird.

Die oben beschriebene Mikrospiegelanordnung eignet sich insbesondere zur Pupillenformung in Beleuchtungssystemen für die Mikrolithographie, die bei einer Wellenlänge von 193 nm betrieben werden. Ferner können auch mehrere Mikrospiegelanordnungen parallel oder nacheinander in solchen Beleuchtungssystemen betrieben werden. Es versteht sich, dass die oben beschriebenen Konzepte mit geeigneten Abwandlungen auch bei anderen Wellenlängen, wie z.B. 248 nm, Verwendung finden können. Ferner kann die oben beschriebene Mikrospiegelanordnung auch in anderen optischen Anlagen bzw. auf anderen Gebieten der Optik als der Mikrolithographie gewinnbringend eingesetzt werden. Wesentlich ist hierbei, dass die Anti-Reflexbeschichtung durch die Fotolithographie strukturiert werden kann, weshalb bei der Strukturierung nur geringe Toleranzen auftreten und die Anti-Reflexbeschichtung nahezu die gesamte Fläche außerhalb der reflektierenden Oberflächen bedecken kann, so dass der "Rahmen" der einzelnen Mikrospiegel im Wesentlichen vollständig mit ihr beschichtet werden kann.

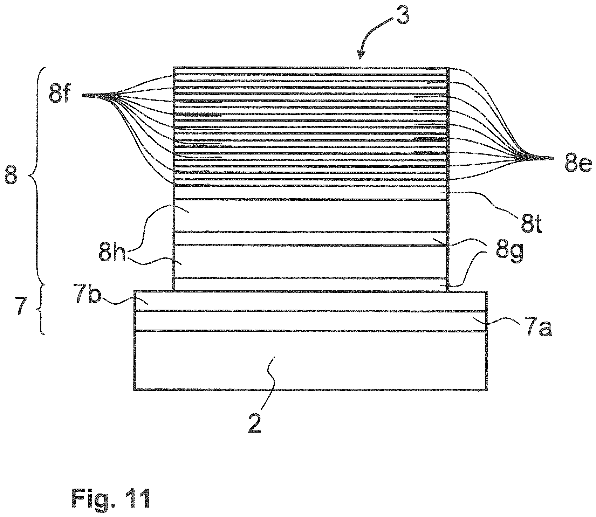

**Fig. 11** ist eine schematische Darstellung des erfindungsgemäßen Schichtaufbaus der Ausführungsbeispiele zu der erfindungsgemäßen Beschichtung eines Mikrospiegels 3 der Mikrospiegelanordnung von Fig. 1a, welches neben der Anti-Reflexbeschichtung 7 mit den Schichten 7a und 7b auf einem Substrat 2 auch die reflektierende Beschichtung 8 mit umfasst. Die reflektierende Beschichtung 8 besteht hierbei aus zwei Schichtteilsysteme, wobei das erste Schichtteilsystem Schichten 8e, 8f aus einer periodischen Abfolge alternierender hoch und niedrig brechender Schichten aus einem nicht-metallischen Material aufweist und bezüglich der Nutzwellenlänge im Hinblick auf die Reflektivität optimiert ist. Das zweite Schichtteilsystem besteht aus den hoch und niedrig brechenden Schichten 8g, 8h und ist bezüglich der Messwellenlänge im Hinblick auf die Reflektivität optimiert. Das Schichtdesign für diese Ausführungsbeispiele lässt sich exemplarisch wie folgt angeben:
(Substrat) Ax(7a, 7b) Bx(8g, 8h) (8t) Cx(8f, 8e),

mit A Perioden der Anti-Reflexbeschichtung 7 bestehend aus den Schichten 7a und 7b, B Perioden des ersten Schichtteilsystems der reflektiven Beschichtung 8 bestehend aus den Schichten 8g und 8h für die Reflektion der Messwellenlänge und C Perioden des zweiten Schichtteilsystems der reflektiven Beschichtung 8 bestehend aus den Schichten 8e und 8f für die Reflektion der Nutzwellenlänge.

Die Zahlen A, B und C für die jeweiligen Perioden der Ausführungsbeispiele können hierbei zwischen 1 und 20 liegen. Als Material für die absorbierende Schicht 7a kommen folgende Materialien in Frage: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}). Als Material für die weitere Schicht 7b der Anti-Reflexbeschichtung 7 kommen folgende Materialien in Frage: SiO₂, MgF₂, LaF₃, Chiolith, Kryolith, Al₂O₃ und ErF₃. Für die Schichten 8g und 8h werden Materialien bevorzugt, welche ausgewählt sind aus der Gruppe umfassend: La₂O₃, ZrO₂, TiO₂, Ta₂O₅, MgF₂, SiO₂, Al₂O₃, Si, Ge, HfO₂, AlF₃. Als Material für die Trennschicht 8t eignet sich ein Material, das ausgewählt ist aus der Gruppe umfassend: TiO₂, Ta₂O₅, HfO₂, ZrO₂, Si, Ge, ZnS, CuInSe₂, CuInS₂, La₂O₃. Für die Schichten 8e und 8f werden Materialien bevorzugt, welche ausgewählt sind aus der Gruppe umfassend: LaF₃, MgF₂, SiO₂, Al₂O₃, ErF₃, GdF₃, HfO₂, AlF₃. Ferner kann eine zusätzliche Haftvermittlungsschicht zwischen der Anti-Reflexbeschichtung 7 und dem Substrat 2 und/ oder zwischen der Anti-Reflexbeschichtung 7 und der reflektierenden Beschichtung 8 bei den Ausführungsbeispielen gemäß Fig. 11 vorgesehen werden. Die Dicken der einzelnen Schichten der Ausführungsbeispiele können hierbei zwischen der Hälfte und dem fünfzehnfachen der Einheit Quarter Wave Optical Thickness (QWOT) bei der Nutzwellenlänge von 193 nm bei nahezu senkrechtem Einfall betragen.

Das oben dargelegte Ausführungsbeispiel zu Fig. 8 stellt hierbei nur ein mögliches konkretes Ausführungsbeispiel aus der Vielzahl an erfindungsgemäßen Ausführungsbeispielen der Fig. 11 dar, welche sich aus den Kombinationen der oben dargelegten Listen an Materialien ergeben und welche dahingehend ausgewählt und in der Wahl der Schichtdicken optimiert werden, dass eine möglichst hohe Reflektivität bei der Nutzwellenlänge und der Messwellenlänge unter dem jeweiligen Einfallswinkel auf der reflektierenden Oberfläche 11 und eine möglichst niedrige Reflektivität außerhalb der reflektierenden Oberfläche 11 erzielt wird.

Aus dieser Vielzahl an Kombinationen ist das Ausführungsbeispiel gemäß Fig. 8 ausgewählt, um dessen Eigenschaften anhand von den Figuren 7, 9 und 10 exemplarisch zu diskutieren. Das Ausführungsbeispiel zu Fig. 8 umfasst dabei konkret die Anti-Reflexbeschichtung 7 gemäß Fig. 7, ein zweites reflektierendes Schichtteilsystem aus zwei Perioden von Schichten 8g aus TiO₂ und Schichten 8h aus MgF₂ für die Wellenlänge 633 nm, eine Trennschicht 8t aus TiO₂ und ein erstes Schichtteilsystem aus 9 Perioden von Schichten 8f aus MgF₂ und 8e aus LaF₃ für die Wellenlänge 193 nm.

Dabei ist die vorliegende Erfindung nicht auf das Ausführungsbeispiel gemäß Fig. 8 beschränkt, sondern umfasst alle Ausführungsbeispiele die sich aus den möglichen Kombinationen von Materialien ergeben, wie sie zur Figurenbeschreibung von Fig. 11 angegeben sind und welche hinsichtlich der vorgegebenen Aufgabenstellung optimiert werden können.

Die vorliegende Erfindung umfasst auch Aspekte, wie sie in Form der folgenden Sätze S1 bis S34 anhand der Ausführungsbeispiele gemäß den Figuren 1a bis 11 dargestellt sind. Diese Sätze S1 bis S34 sind Teil der vorliegenden Beschreibung und stellen somit keine Patentansprüche gemäß der Entscheidung J15/88 der Beschwerdekammern des Europäischen Patentamts dar:
S1: Mikrospiegelanordnung 1 umfassend:
   mindestens einen Mikrospiegel 3 mit einer reflektierenden Oberfläche 11, die an einem Spiegelsubstrat 2 gebildet ist, sowie eine reflektierende Beschichtung 8, die an dem Spiegelsubstrat 2 innerhalb der reflektierenden Oberfläche 11 gebildet ist, dadurch gekennzeichnet, dass die reflektierende Beschichtung 8 wenigstens zwei Schichtteilsysteme aufweist, wobei das erste Schichtteilsystem Schichten 8e und 8f aus einer periodischen Abfolge alternierender hoch und niedrig brechender Schichten aus einem nicht-metallischen Material aufweist und bezüglich einer Nutzwellenlänge der Mikrospiegelanordnung im Hinblick auf die Reflektivität optimiert ist und wobei das zweite Schichtteilsystem bezüglich einer von der Nutzwellenlänge abweichenden Messwellenlänge der Mikrospiegelanordnung im Hinblick auf die Reflektivität optimiert ist.
S2: Mikrospiegelanordnung nach Satz S1, wobei das Spiegelsubstrat 2 aus Silizium besteht und die reflektierende Beschichtung 8 eine strukturierte Beschichtung ist, wobei die Strukturierung der reflektierenden Beschichtung 8 dadurch gegeben ist, dass sich die reflektierende Beschichtung 8 nur innerhalb der reflektierenden Oberfläche 11 des Mikrospiegels 3 erstreckt.
S3: Mikrospiegelanordnung nach Satz S1, wobei die reflektierende Beschichtung 8 mindestens eine Trennschicht 8t zwischen den zwei Schichtteilsystemen aufweist, wobei das Material der Trennschicht 8t ein Material ist, das ausgewählt ist aus der Gruppe umfassend: TiO₂, Ta₂O₅, HfO₂, ZrO₂, Si, Ge, ZnS, CuInSe₂, CuInS₂, La₂O₃.
S4: Mikrospiegelanordnung nach einem der vorhergehenden Sätze, bei der die Materialien der Schichten 8e und 8f des ersten Schichtteilsystems Materialien sind, welche ausgewählt sind aus der Gruppe umfassend: LaF₃, MgF₂, SiO₂, Al₂O₃, ErF₃, GdF₃, HfO₂, AlF₃.
S5: Mikrospiegelanordnung nach einem der vorhergehenden Sätze, bei der die Materialien der Schichten 8g und 8h des zweiten Schichtteilsystems Materialien sind, welche ausgewählt sind aus der Gruppe umfassend: La₂O₃, ZrO₂, TiO₂, Ta₂O₅, MgF₂, SiO₂, Al₂O₃, Si, Ge, HfO₂, AlF₃.
S6: Mikrospiegelanordnung nach einem der vorhergehenden Sätze, bei der der mindestens einen Mikrospiegel 3 eine Anti-Reflexbeschichtung 7 aufweist, die an dem Spiegelsubstrat 2 außerhalb der reflektierenden Oberfläche 11 gebildet ist, dadurch gekennzeichnet, dass die Anti-Reflexbeschichtung 7 wenigstens eine absorbierende Schicht 7a aus einem nicht-metallischen Material aufweist, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist.
S7: Mikrospiegelanordnung nach Satz S6, wobei das Material der absorbierenden Schicht 7a ein Material ist, das ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}).
S8: Mikrospiegelanordnung nach Satz S6, bei der auf die absorbierende Schicht 7a mindestens eine weitere Schicht 7b mit einem niedrigeren Brechungsindex als dem Brechungsindex der absorbierenden Schicht aufgebracht ist.
S9: Mikrospiegelanordnung nach Satz S6, wobei das Spiegelsubstrat 2 aus Silizium besteht und die Anti-Reflexbeschichtung 7 eine strukturierte Beschichtung ist, wobei die Strukturierung der Anti-Reflexbeschichtung 7 zumindest dadurch gegeben ist, dass sich die Anti-Reflexbeschichtung 7 nur auβerhalb der reflektierenden Oberfläche 11 des Mikrospiegels 3 erstreckt.
S10: Mikrospiegelanordnung nach Satz S6, bei der die Anti-Reflexbeschichtung 7 an dem Spiegelsubstrat 2 auch innerhalb der reflektierenden Oberfläche 11 gebildet ist und bei dem die Anti-Reflexbeschichtung 7 und die reflektierende Beschichtung innerhalb der reflektierenden Oberfläche 11 eine Gesamtspannung der Beschichtung von kleiner als 100 N/m, insbesondere kleiner als 30 N/m aufweist.
S11: Mikrospiegelanordnung nach Satz S6, bei der die Dicke der wenigstens einen absorbierenden Schicht 7a zwischen 40 nm und 100 nm, bevorzugt zwischen 60 nm und 80 nm liegt und bei der die Anti-Reflexbeschichtung 7 bei einer Nutzwellenlänge von 193 nm oder bei einer Nutzwellenlänge von 248 nm unter senkrechtem Einfall eine Reflektivität von 5 % oder weniger, bevorzugt von 3 % oder weniger, insbesondere von 1 % oder weniger aufweist.
S12: Mikrospiegelanordnung nach einem der vorhergehenden Sätze, wobei die reflektierende Beschichtung 8, insbesondere das erste Schichtteilsystem bei einer Nutzwellenlänge von 193 nm oder bei einer Nutzwellenlänge von 248 nm unter einem Einfallswinkel zwischen 0°und 25° zur Normalen der reflektierenden Oberfläche 11 eine Reflektivität von mehr als 65 %, bevorzugt mehr als 80 %, insbesondere von mehr als 95 % aufweist.
S13: Mikrospiegelanordnung nach einem der vorhergehenden Sätze, wobei die reflektierende Beschichtung 8, insbesondere das zweite Schichtteilsystem derart ausgelegt ist, dass eine Reflektivität von mehr als 65 %, insbesondere von mehr als 80 % bei einer von der Nutzwellenlänge abweichenden Messwellenlänge unter einem Einfallswinkel zur Normalen der reflektierenden Oberfläche 11 resultiert, wobei der Einfallswinkel um mehr als 15°, insbesondere um mehr als 20° von einem Einfallswinkel des Nutzlichtes abweicht und wobei die Einfallswinkel des Nutzlichtes durch die beabsichtigte Nutzung der Mikrospiegelanordnung vorgegeben sind.
S14: Mikrospiegelanordnung nach einem der vorhergehenden Sätze, wobei die Mikrospiegelanordnung 1 mindestens eine Haftvermittlungsschicht aufweist, die zur Haftvermittlung der reflektierenden Beschichtung 8 auf der Anti-Reflexbeschichtung 7 oder zur Haftvermittlung der Anti-Reflexbeschichtung 7 auf dem Substrat dient.
S15: Verfahren zum Herstellen einer Beschichtung für eine Mikrospiegelanordnung 1, umfassend: Beschichten eines Spiegelsubstrats 2 mit einer Anti-Reflexbeschichtung 7, sowie Strukturieren der Anti-Reflexbeschichtung 7 unter Aufbringen einer durch Bestrahlung strukturierbaren Materialschicht 9b auf die Anti-Reflexbeschichtung 9 und/oder auf das Spiegelsubstrat 2.
S16: Verfahren nach Satz S15, bei dem das Spiegelsubstrat 2 mit wenigstens einer absorbierenden Schicht 7a aus einem nicht-metallischen Material beschichtet wird, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist.
S17: Verfahren nach Satz S16, bei dem als Material der absorbierenden Schicht 7a ein Material ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}).
S18: Verfahren nach Satz S16 oder S17, bei dem auf die absorbierende Schicht 7a mindestens eine weitere Schicht 7b mit einem niedrigeren Brechungsindex als dem Brechungsindex der absorbierenden Schicht 7a aufgebracht wird.
S19: Verfahren nach einem der Sätze S15 bis S18, weiter umfassend:
   Aufbringen einer reflektierenden Beschichtung 8 auf die Anti-Reflexbeschichtung 7 und/oder auf das Spiegelsubstrat 2 zur Erzeugung mindestens einer reflektierenden Oberfläche 11 an einem Mikrospiegel 3.
S20: Verfahren nach Satz S19, bei dem die reflektierende Beschichtung 8 zunächst flächig aufgebracht und nachfolgend selektiv außerhalb der reflektierenden Oberfläche 11 von der Anti-Reflexbeschichtung entfernt wird.
S21: Verfahren nach einem der Sätze S19 oder S20, bei dem die Schichtspannung der Anti-Reflexbeschichtung 7 so auf die Schichtspannung der reflektierenden Beschichtung 8 abgestimmt ist, dass beide Schichtspannungen sich im Wesentlichen kompensieren.
S22: Verfahren nach einem der Sätze S15 bis S21, bei dem die Anti-Reflexbeschichtung 7 zunächst flächig auf das Spiegelsubstrat 2 aufgebracht und nachfolgend selektiv im Bereich der reflektierenden Oberfläche 11 von dem Spiegelsubstrat 2 entfernt wird.
S23: Mikrospiegelanordnung 1 umfassend: mindestens einen Mikrospiegel 3 mit einer reflektierenden Oberfläche 11, die an einem bevorzugt aus Silizium bestehenden Spiegelsubstrat 2 gebildet ist, sowie eine Anti-Reflexbeschichtung 7, die an dem Spiegelsubstrat 2 außerhalb der reflektierenden Oberfläche 11 gebildet ist, dadurch gekennzeichnet, dass die bevorzugt strukturierte Anti-Reflexbeschichtung 7 wenigstens eine absorbierende Schicht 7a aus einem bevorzugt nicht-metallischen Material aufweist, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist.
S24: Mikrospiegelanordnung nach Satz S23, bei der das Material der absorbierenden Schicht 7a eine Silizium-Stickstoff-Verbindung ist, die bevorzugt ausgewählt ist aus der Gruppe umfassend: Silizium-Nitride (SiₓN_{y}) und Silizium-Oxid-Nitride (SiNₓO_{y}).
S25: Mikrospiegelanordnung nach Satz S23 oder S24, bei der auf die absorbierende Schicht 7a mindestens eine weitere Schicht 7b mit einem niedrigeren Brechungsindex als dem Brechungsindex der absorbierenden Schicht aufgebracht ist.
S26: Mikrospiegelanordnung nach Satz S25, bei der die weitere Schicht 7b aus einer Silizium-Sauerstoff-Verbindung, insbesondere aus Siliziumdioxid (SiO₂) besteht.
S27: Mikrospiegelanordnung nach einem der vorhergehenden Sätze S23 bis S26, bei der alle Schichten 7a und 7b der Anti-Reflexbeschichtung 7 aus nicht-metallischen Materialen, insbesondere aus Silizium-Verbindungen, bestehen.
S28: Mikrospiegelanordnung nach einem der vorhergehenden Sätze S23 bis S27, bei der die Dicke der wenigstens einen absorbierenden Schicht 7a so gewählt ist, dass die auf die absorbierende Schicht 7a auftreffende Strahlung vollständig absorbiert wird.
S29: Mikrospiegelanordnung nach Satz S28, bei der die Dicke der wenigstens einen absorbierenden Schicht 7a zwischen 40 nm und 100 nm, bevorzugt zwischen 60 nm und 80 nm liegt.
S30: Mikrospiegelanordnung nach einem der vorhergehenden Sätze S23 bis S29, bei der die Anti-Reflexbeschichtung 7 bei einer Wellenlänge von 193 nm unter senkrechtem Einfall eine Reflektivität von 5 % oder weniger, bevorzugt von 3 % oder weniger, insbesondere von 1 % oder weniger aufweist.
S31: Mikrospiegelanordnung nach einem der vorhergehenden Sätze S23 bis S30, bei der die Anti-Reflexbeschichtung 7 unter senkrechtem Einfall in einem Wellenlängenbereich zwischen 185 nm und 210 nm, insbesondere bis 230 nm eine Reflektivität von 10 % oder weniger, bevorzugt von 5 % oder weniger aufweist.
S32: Mikrospiegelanordnung nach einem der vorhergehenden Sätze S23 bis S31, bei der die reflektierende Oberfläche 11 an einer reflektierenden Beschichtung 8 gebildet ist, die bevorzugt auf die Anti-Reflexbeschichtung 7 und/oder auf das Spiegelsubstrat 2 aufgebracht ist.
S33: Mikrospiegelanordnung nach Satz S32, bei der die Schichtspannung der Anti-Reflexbeschichtung 7 die Schichtspannung der reflektierenden Beschichtung 8 im Wesentlichen kompensiert.
S34: Mikrospiegelanordnung nach einem der vorhergehenden Sätze S23 bis S33, weiter umfassend eine Stützstruktur 5, an welcher der mindestens eine Mikrospiegel 3 beweglich gelagert ist.

## Patentansprüche

1. Mikrospiegelanordnung (1), umfassend:
mindestens einen Mikrospiegel (3) mit einer reflektierenden Oberfläche (11), die an einem Spiegelsubstrat (2) gebildet ist, sowie
eine reflektierende Beschichtung (8), die an dem Spiegelsubstrat (2) innerhalb der reflektierenden Oberfläche (11) gebildet ist, **dadurch gekennzeichnet,**
**dass** die reflektierende Beschichtung (8) wenigstens zwei Schichtteilsysteme aufweist, wobei das erste Schichtteilsystem Schichten (8a, 8b; 8e, 8f) aus einer periodischen Abfolge alternierender hoch und niedrig brechender Schichten aus einem nicht-metallischen Material aufweist und bezüglich einer Nutzwellenlänge der Mikrospiegelanordnung im Hinblick auf die Reflektivität optimiert ist und wobei das zweite Schichtteilsystem bezüglich einer von der Nutzwellenlänge abweichenden Messwellenlänge der Mikrospiegelanordnung im Hinblick auf die Reflektivität optimiert ist.

2. Mikrospiegelanordnung nach Anspruch 1, wobei die reflektierende Beschichtung (8) mindestens eine Trennschicht (8t) zwischen den zwei Schichtteilsystemen aufweist, wobei das Material der Trennschicht (8t) ein Material ist, das ausgewählt ist aus der Gruppe umfassend: TiO₂, Ta₂O₅, HfO₂, ZrO₂, Si, Ge, ZnS, CuInSe₂, CuInS₂, La₂O₃.

3. Mikrospiegelanordnung nach einem der Ansprüche 1 bis 2, bei der die Materialien der Schichten (8a, 8b; 8e, 8f) des ersten Schichtteilsystems Materialien sind, welche ausgewählt sind aus der Gruppe umfassend: LaF₃, MgF₂, SiO₂, Al₂O₃, ErF₃, GdF₃, HfO₂, AlF₃.

4. Mikrospiegelanordnung nach einem der Ansprüche 1 bis 3, bei der die Materialien der Schichten (8c, 8d; 8g, 8h) des zweiten Schichtteilsystems Materialien sind, welche ausgewählt sind aus der Gruppe umfassend: La₂O₃, ZrO₂, TiO₂, Ta₂O₅, MgF₂, SiO₂, Al₂O₃, Si, Ge, HfO₂, AlF₃.

5. Mikrospiegelanordnung nach Anspruch 1, bei der der mindestens eine Mikrospiegel (3) eine Anti-Reflexbeschichtung (7) aufweist, die an dem Spiegelsubstrat (2) außerhalb der reflektierenden Oberfläche (11) gebildet ist,
**dadurch gekennzeichnet,**
**dass** die Anti-Reflexbeschichtung (7) wenigstens eine absorbierende Schicht (7a) aus einem nicht-metallischen Material aufweist, das bei einer Wellenlänge im UV-Bereich, insbesondere bei 193 nm, einen Absorptionskoeffizienten von 0,1 oder mehr, bevorzugt von 0,2 oder mehr, insbesondere von 0,4 oder mehr aufweist.

6. Mikrospiegelanordnung nach Anspruch 5, wobei das Material der absorbierenden Schicht (7a) ein Material ist, das ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}).

7. Mikrospiegelanordnung nach Anspruch 5, bei der die Anti-Reflexbeschichtung (7) an dem Spiegelsubstrat (2) auch innerhalb der reflektierenden Oberfläche (11) gebildet ist und bei dem die Anti-Reflexbeschichtung (7) und die reflektierende Beschichtung innerhalb der reflektierenden Oberfläche (11) eine Gesamtspannung der Beschichtung von kleiner als 100 N/m, insbesondere kleiner als 30 N/m aufweist.

8. Mikrospiegelanordnung nach Anspruch 5, bei der die Dicke der wenigstens einen absorbierenden Schicht (7a) zwischen 40 nm und 100 nm, bevorzugt zwischen 60 nm und 80 nm liegt und bei der die Anti-Reflexbeschichtung (7) bei einer Nutzwellenlänge von 193 nm oder bei einer Nutzwellenlänge von 248 nm unter senkrechtem Einfall eine Reflektivität von 5 % oder weniger, bevorzugt von 3 % oder weniger, insbesondere von 1 % oder weniger aufweist.

9. Mikrospiegelanordnung nach einem der Ansprüche 1 bis 8, wobei die reflektierende Beschichtung (8), insbesondere das erste Schichtteilsystem bei einer Nutzwellenlänge von 193 nm oder bei einer Nutzwellenlänge von 248 nm unter einem Einfallswinkel zwischen 0°und 25° zur Normalen der reflektierenden Oberfläche (11) eine Reflektivität von mehr als 65 %, bevorzugt mehr als 80 %, insbesondere von mehr als 95 % aufweist.

10. Mikrospiegelanordnung nach einem der Ansprüche 1 bis 9, wobei die reflektierende Beschichtung (8), insbesondere das zweite Schichtteilsystem derart ausgelegt ist, dass eine Reflektivität von mehr als 65 %, insbesondere von mehr als 80 % bei einer von der Nutzwellenlänge abweichenden Messwellenlänge unter einem Einfallswinkel zur Normalen der reflektierenden Oberfläche (11) resultiert, wobei der Einfallswinkel um mehr als 15°, insbesondere um mehr als 20° von einem Einfallswinkel des Nutzlichtes abweicht und wobei die Einfallswinkel des Nutzlichtes durch die beabsichtigte Nutzung der Mikrospiegelanordnung vorgegeben sind.

11. Mikrospiegelanordnung nach einem der Ansprüche 5 bis 10, wobei auf die absorbierende Schicht (7a) mindestens eine weitere Schicht (7b) aufgebracht ist und wobei die weitere Schicht (7b) aus HfO₂, MgF2, LaF3, Chiolith, Kryolith, Al2O3, ErF3 oder einer Silizium-Sauerstoff-Verbindung, insbesondere aus Siliziumdioxid (SiO₂) zusammengesetzt ist.

12. Verfahren zum Herstellen einer Beschichtung für eine Mikrospiegelanordnung (1), umfassend:
Beschichten eines Spiegelsubstrats (2) mit einer Anti-Reflexbeschichtung (7), sowie Strukturieren der Anti-Reflexbeschichtung (7) unter Aufbringen einer durch Bestrahlung strukturierbaren Materialschicht (9b) auf die Anti-Reflexbeschichtung (9) und/oder auf das Spiegelsubstrat (2), wobei als Material der absorbierenden Schicht (7a) ein Material ausgewählt ist aus der Gruppe umfassend: TiO₂, Ta₂O₃, Ta₂O₅, HfO₂, ZrO₂, Chrom-Oxide (CrₓO_{y}), PbF₂, YF₃, C, diamantähnlicher Kohlenstoff, Ge, Si, SiN, Silizium-Nitride (SiₓN_{y}), Silizium-Oxid-Nitride (SiNₓO_{y}) und nicht-stöchiometrische Silizium-Oxide (SiₓO_{y}) und wobei das Verfahren des weiteren umfasst:
Aufbringen einer reflektierenden Beschichtung (8) auf die Anti-Reflexbeschichtung (7) und/oder auf das Spiegelsubstrat (2) zur Erzeugung mindestens einer reflektierenden Oberfläche (11) an einem Mikrospiegel (3).

13. Verfahren nach Anspruch 12, bei dem die reflektierende Beschichtung (8) zunächst flächig aufgebracht und nachfolgend selektiv außerhalb der reflektierenden Oberfläche (11) von der Anti-Reflexbeschichtung entfernt wird.

14. Verfahren nach einem der Ansprüche 12 oder 13, bei dem die Schichtspannung der Anti-Reflexbeschichtung (7) so auf die Schichtspannung der reflektierenden Beschichtung (8) abgestimmt ist, dass beide Schichtspannungen sich im Wesentlichen kompensieren.

15. Verfahren nach einem der Ansprüche 12 bis 14, bei dem die reflektierende Beschichtung (8) wenigstens zwei Schichtteilsysteme aufweist, wobei das erste Schichtteilsystem Schichten (8a, 8b; 8e, 8f) aus einer periodischen Abfolge alternierender hoch und niedrig brechender Schichten aus einem nicht-metallischen Material aufweist und bezüglich einer Nutzwellenlänge der Mikrospiegelanordnung im Hinblick auf die Reflektivität optimiert ist und wobei das zweite Schichtteilsystem bezüglich einer von der Nutzwellenlänge abweichenden Messwellenlänge der Mikrospiegelanordnung im Hinblick auf die Reflektivität optimiert ist, wobei die reflektierende Beschichtung (8) mindestens eine Trennschicht (8t) zwischen den zwei Schichtteilsystemen aufweist und das Material der Trennschicht (8t) ein Material ist, das ausgewählt ist aus der Gruppe umfassend: TiO₂, Ta₂O₅, HfO₂, ZrO₂, Si, Ge, ZnS, CuInSe₂, CuInS₂, La₂O₃, und wobei die Materialien der Schichten (8a, 8b; 8e, 8f) des ersten Schichtteilsystems Materialien sind, welche ausgewählt sind aus der Gruppe umfassend: LaF₃, MgF₂, SiO₂, Al₂O₃, ErF₃, GdF₃, HfO₂, AlF₃ und wobei die Materialien der Schichten (8c, 8d; 8g, 8h) des zweiten Schichtteilsystems Materialien sind, welche ausgewählt sind aus der Gruppe umfassend: La₂O₃, ZrO₂, TiO₂, Ta₂O₅, MgF₂, SiO₂, Al₂O₃, Si, Ge, HfO₂, AIF₃.
